(19) Europäisches Patentamt
European Patent Office
Office européen des brevets

(11) Publication number: 0 355 810 A2

# (12) EUROPEAN PATENT APPLICATION

(21) Application number: 89115561.6

(51) Int. Cl.4: G03F 7/038

(22) Date of filing: 23.08.89

(30) Priority: 24.08.88 JP 209749/88
03.03.89 JP 52676/89

(43) Date of publication of application:
28.02.90 Bulletin 90/09

(84) Designated Contracting States:
BE DE FR GB

(71) Applicant: KANEGAFUCHI KAGAKU KOGYO KABUSHIKI KAISHA
2-4 Nakanoshima 3-chome
Kita-ku Osaka-shi Osaka-fu(JP)

(72) Inventor: Miyazaki, Seiichi
5-21, Yoshijima-cho Naka-ku
Hiroshima-shi Hiroshima(JP)
Inventor: Uekita, Masakazu
5-21, Takaha-cho 5-chome Nada-ku
Kobe-shi Hyogo(JP)

(74) Representative: Vossius & Partner
Siebertstrasse 4 P.O. Box 86 07 67
D-8000 München 86(DE)

## (54) Process for the production of patterned thin film.

(57) A process for the production of a patterned thin film that comprises building-up a polymer compound, optionally together with a known LB film compound, by the Langmuir-Blodgett technique and irradiating the built-up film thus formed with an excimer laser of a high energy density is disclosed. According to the process of the present invention, a patterned thin film excellent in heat resistance, chemical resistance and mechanical properties can be obtained without requiring any troublesome development procedure.

EP 0 355 810 A2

# PROCESS FOR THE PRODUCTION OF PATTERNED THIN FILM

This invention relates to a process for the production of a patterned thin film. More particularly, it relates to a process for forming a pattern which comprises building-up a polymer compound which has been modified in such a manner as to enable building-up by the Langmuir-Blodgett technique, which will be called the LB technique hereinafter, and irradiating the obtained built-up material with an excimer laser. Furthermore, it relates to a process for the production of a patterned and heat-resistant thin film (hereinafter referred to simply as "thin film") comprising forming a five- or six-membered ring when the above-mentioned modified polymer compound has a precursor structure capable of forming a five- or six-membered ring.

Langmuir and Blodgett found in the 1930s that a fatty acid having about 16 to 22 carbon atoms would form a monomolecular film on the surface of water and the obtained film could be built-up on a substrate. Recently, the above finding has been, at long last, applied to technical purposes.

Conventional studies on this subject are summarized in, for example, Kotai Butsuri 17 (12), 45 (1982); "Thin Solid Films", 68, No. 1 (1980); ibid., 99, No. 1.2.3 (1983) and "Insoluble Monolayers at Liquid-gas Interfaces" [G.L. Gains, Interscience Publishers, New York (1966)]. However, known Langmuir-Blodgett films, which will be called LB films hereinafter, are disadvantageous in that they are poor in heat resistance and mechanical strength, and thus unavailable for use in practice.

Therefore, it has been attempted to overcome this disadvantage by forming polymer films by using, for example, unsaturated fatty acids such as ω-tricosenoic acid, ω-heptadecenoic acid or α-octadecylacrylic acid or unsaturated ester of fatty acids such as vinyl stearate, octadecyl acrylate or diacetylene derivatives. However, none of these polymer films have satisfactory heat resistance or excellent electrical properties. It is known that some polymers having hydrophilic groups such as polyacrylic acids, polyvinyl alcohols, ethyl acrylate or polypeptides have film-forming properties. However, it has never before been attempted hitherto to use a modified polymer in the production of, in particular, a LB film. Further, there is no known polymer readily available as a material for the production of an LB film.

It has previously been found that a polymer compound, which had been made hydrophobic by introducing a substituent into the repeating unit thereof to improve the heat resistance and mechanical strength, could be deposited into a film by the LB technique; and said polymer compound could be reacted to give a heat resistant polymer film having a five-or six-membered ring when said compound had a precursor structure capable of forming a five- or six-membered ring (cf. JP-A-63-21828 and 63-3024).

In order to use effectively the above-mentioned film in the fields of, for example, electronics, it is desired to pattern it in such a manner that said film is exclusively patterned only in required areas. Thus, further studies have been performed and a process for the patterning of said film proposed (cf. Japanese patent Application No. 241640/1987). However, a conventional patterning process after UV-irradiation requires a complicated procedure, namely, the dissolution of the exposed or unexposed part with a developing agent and the removal of the same. Thus, the pattern formed is frequently unstable depending on the development conditions. Furthermore, the obtained product is sometimes contaminated with impurities contained in the developing agent. Accordingly, it has been desirable to establish a process for patterning without requiring any development procedure.

It is the object of the invention to provide an improved process for patterning. This object has been achieved by the finding that a directly patterned thin film can be obtained by building-up a polymer compound, and without requiring any development procedure.

According to the present invention, there is provided a direct patterned thin film with linear repeating units, wherein a first organic group $R^1$ having at least two carbon atoms and at least 2 valences and a second organic group $R^2$ having at least two carbon atoms and at least 2 valences, are alternately bound to each other via a divalent binding group formed by a reaction between an acidic group A containing at least one hetero atom and a basic group B containing at least one hetero atom, and at least one hydrocarbon-containing group $R^3$ having 10 to 30 carbon atoms and optionally containing substituent(s) is bound to said repeating unit via a covalent or ionic bond. The polymer compound of said film is optionally mixed together with a known LB film compound, followed by the building-up of said film and irradiating the built-up film thus obtained with an excimer laser of a high energy density to thereby remove the irradiated part of the film. A patterned heat-resistant thin film can be obtained by reacting the patterned film when it has a precursor structure capable of forming a five- or six-membered ring.

Figs. 1 to 7 each show a typical model of a device of an MIS structure, Figs. 8 to 10 each show that of an MIM structure, while Figs. 11 to 13 show each that of an IM structure.

The polymer compound to be used in the present invention may be selected from among those which

are described in JP-A-63-218728, and 63-3024 .

More particularly, it may be a polymer compound having linear repeating units wherein the first organic group $R^1$ having at least two carbon atoms and at least 2 valences and the second organic group $R^2$ having at least two carbon atoms and at least 2 valences are alternately bound to each other via a divalent binding group and at least one, preferably two, hydrocarbon-containing groups $R^3$ having 10 to 30 carbon atoms and optionally containing substituent(s) is bound to said repeating unit via a covalent bond so as to make the compound hydrophobic. Alternatively, the hydrophobic nature may be imparted to the polymer compound by an ionic bond. A polymer compound to which a hydrophobic nature is imparted by an ionic bond has a repeating unit wherein the first organic group $R^1$ having at least two carbon atoms and at least 3 valences and the second organic group $R^2$ having at least two carbon atoms and at least 2 valences are alternately bound via a divalent binding group, and at least one hydrocarbon-containing group $R^3$ having 10 to 30 carbon atoms and optionally substituent(s) is bound to said repeating unit via an ionic bond.

Among these polymer compounds those wherein either or both of the first and second organic groups $R^1$ and $R^2$ are benzenoid structure groups having at least six carbon atoms are preferred since a film having high thermal resistance can be obtained in such a case. In this case, furthermore, it seems that the UV absorption band of the benzenoid structure would promote the efficient absorption of UV light by the film.

In addition, it is preferred that the polymer compound has a precursor structure capable of forming a five- or six-membered ring. This is because such a structure can be converted into a five- or six-membered ring structure excellent in heat resistance.

Preferred examples of the polymer compound to which a hydrophobic group has been introduced via a covalent bond are as follows.

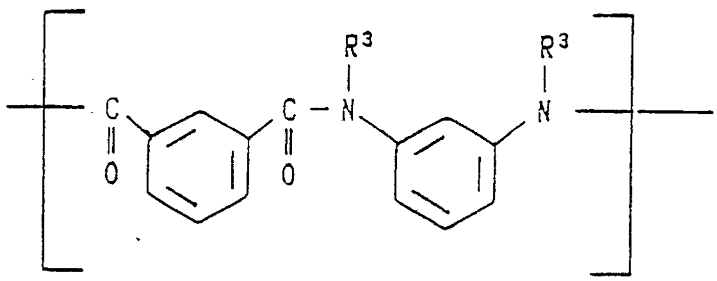

(1);

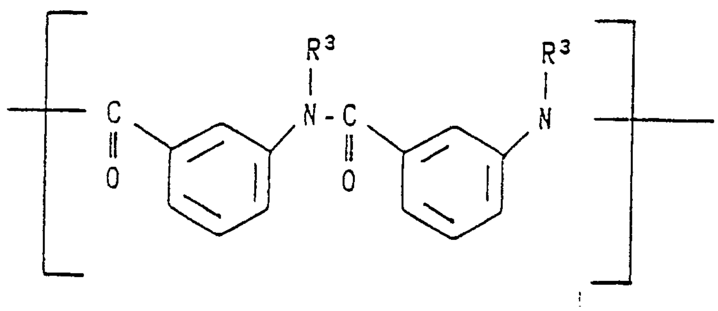

(2);

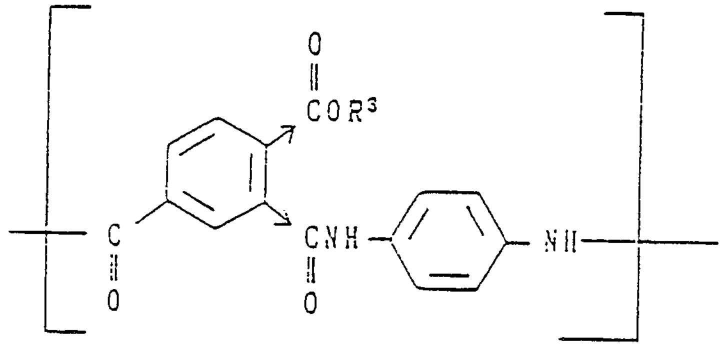

(3);

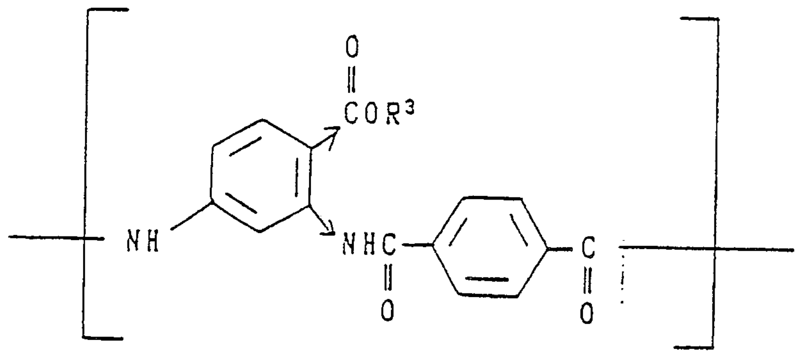

(4);

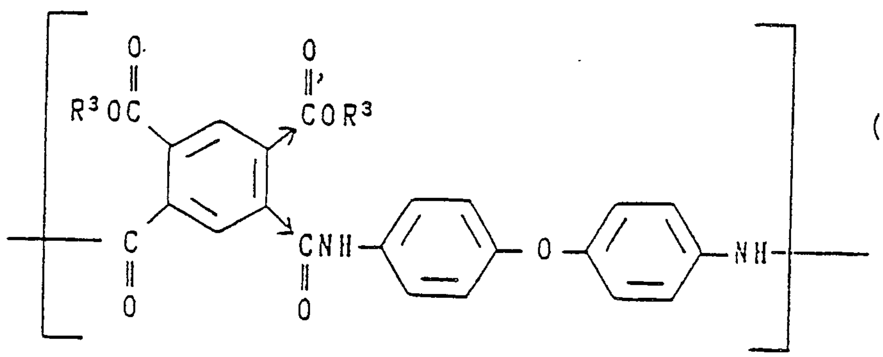

(5);

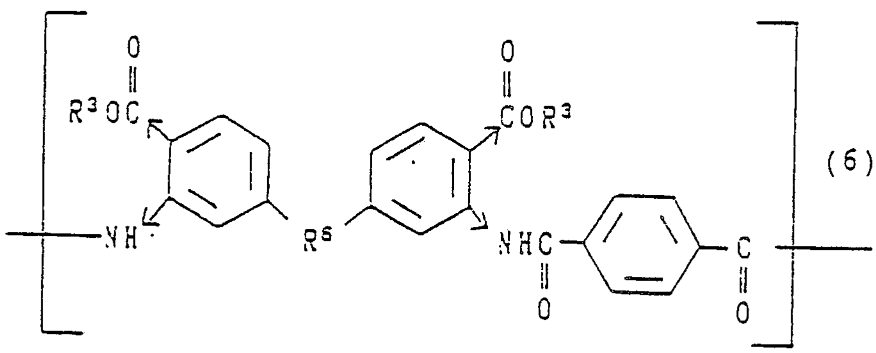

(6);

wherein $R^6$ represents a

$-(CH_2)n-$ ( n = 1 ~ 3 ) , 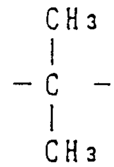 , 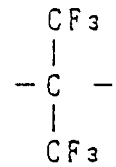 ,

$-O-$, $-CO-$, $-S-$, $-SO_2-$,

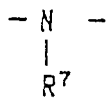 , 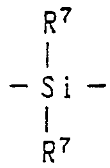 , 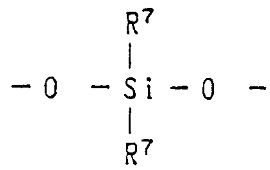 ,

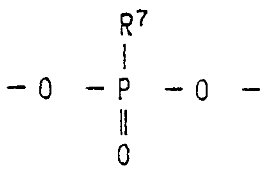 , 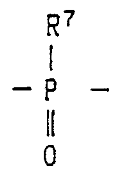

$R^7$ represents an alkyl or an aryl group;

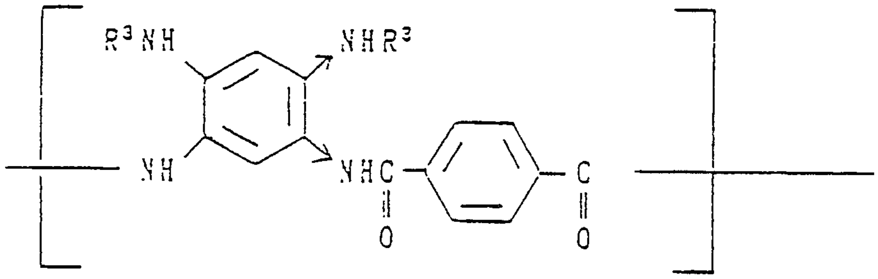

(7);

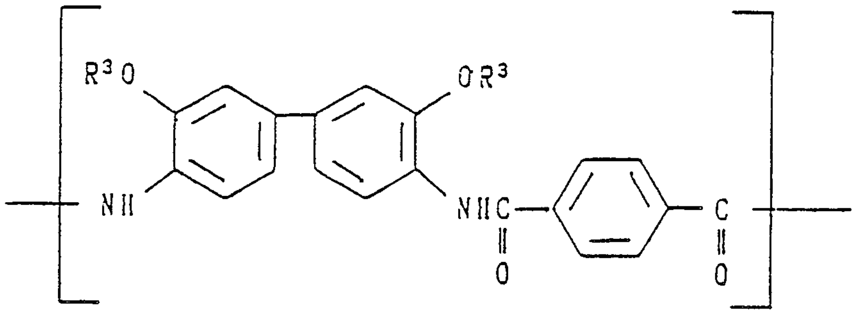

(8);

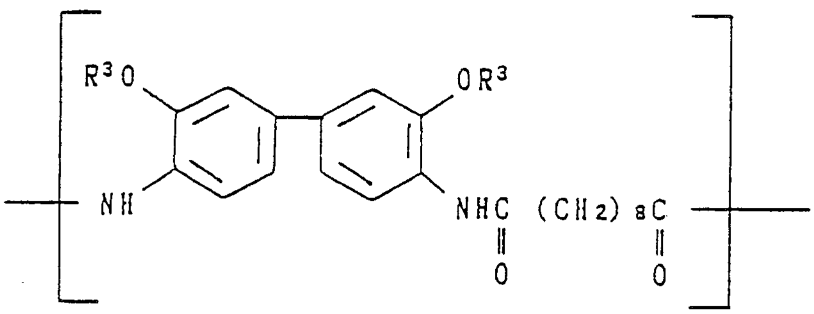

(9);

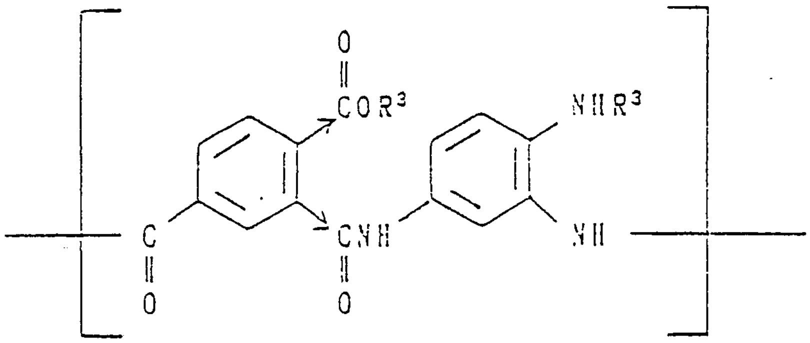

(10);

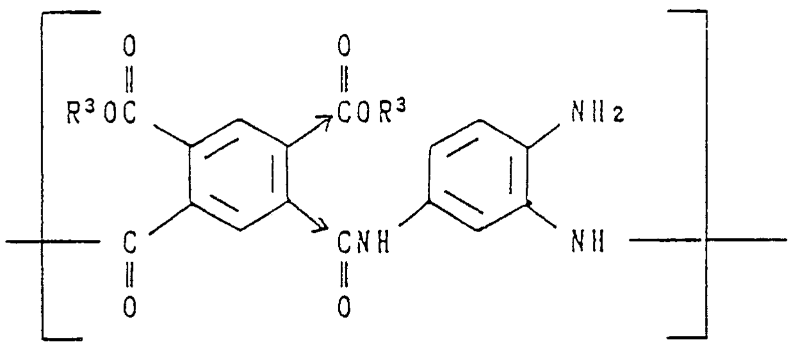

(11);

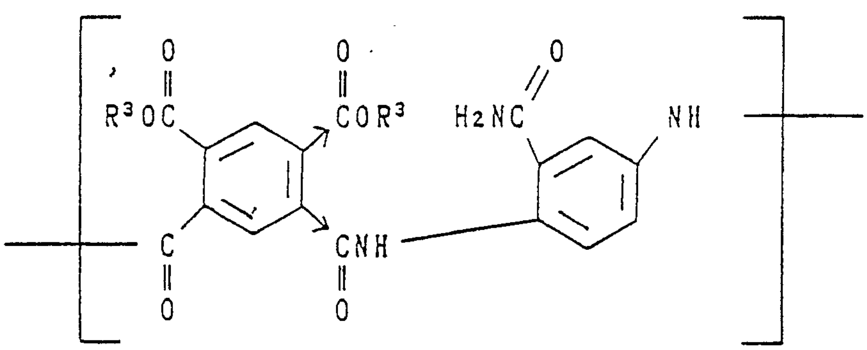

(12);

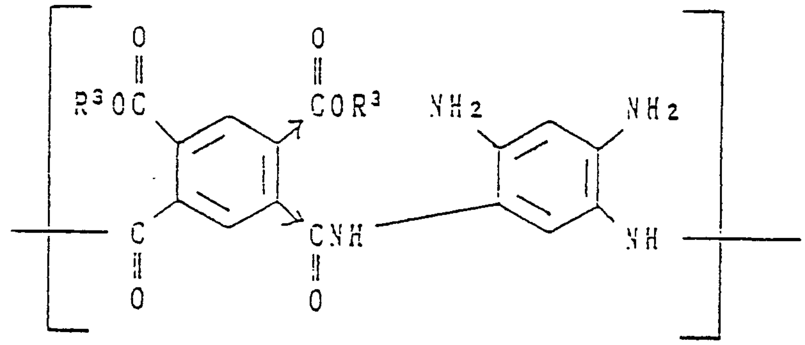

(13);

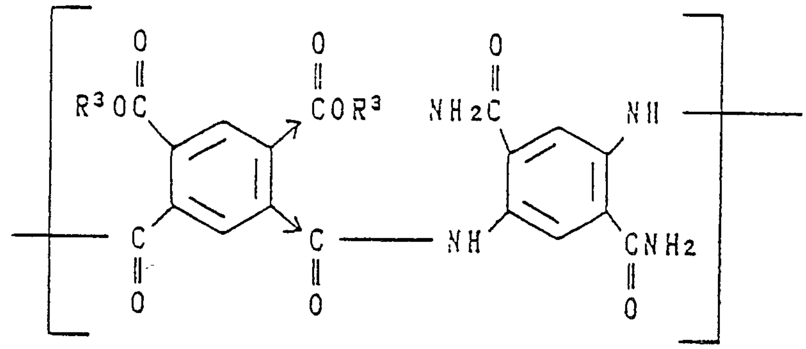

(14);

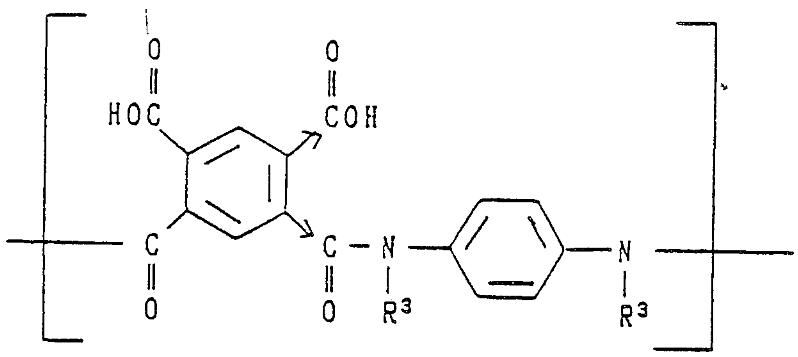

(15);

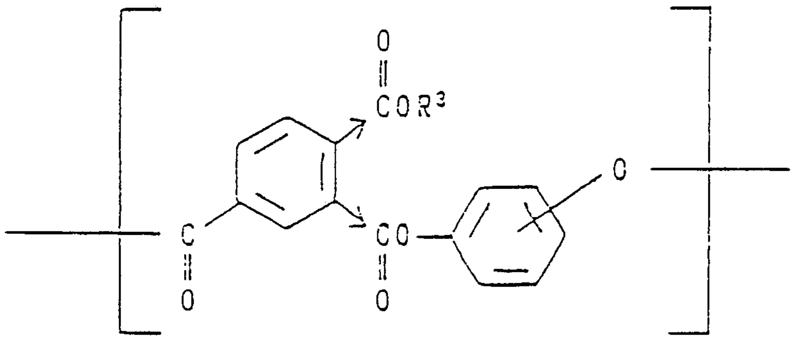

(16);

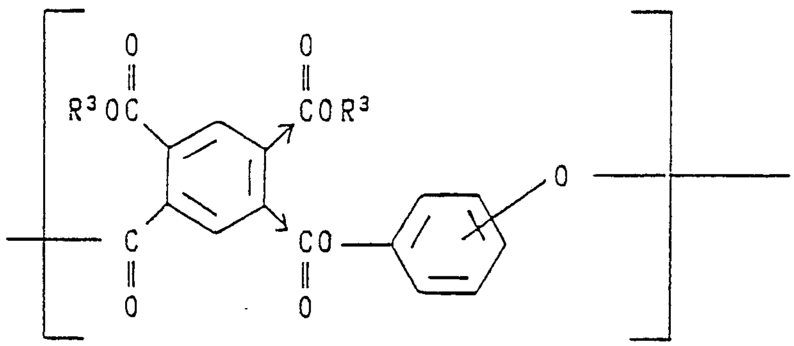

(17);

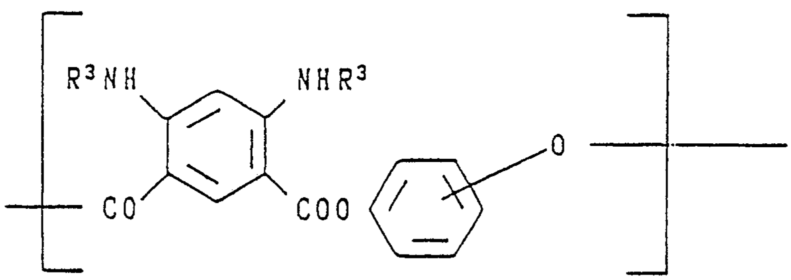

(18);

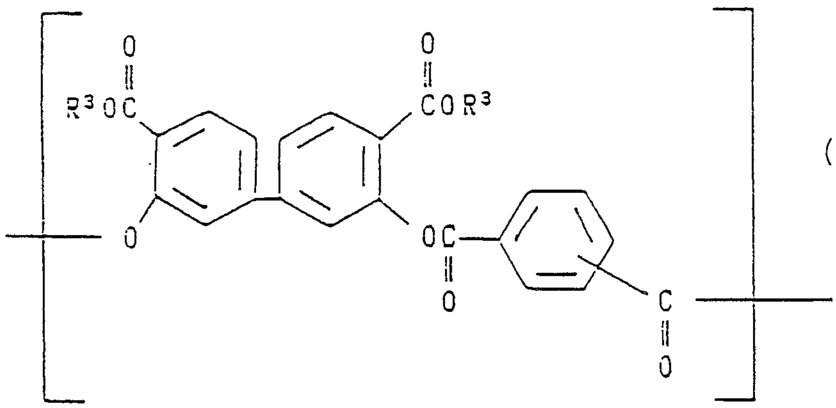

(19); and

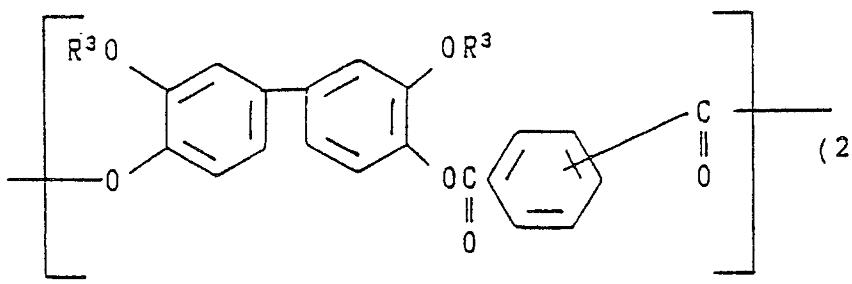

(20).

In the above formulae (1) to (20), $R^3$ represents a hydrocarbon-containing group having 10 to 30, preferably 16 to 22 carbon atoms. A preferred example thereof is a monovalent group selected from aliphatic groups, those wherein an alicyclic group is bound to an aliphatic one and those wherein an aromatic group is bound to an aliphatic one, each optionally substituted. Examples thereof are as follows:

$CH_3(CH_2)_{n-1}$

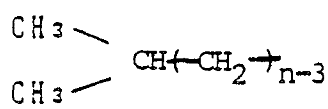

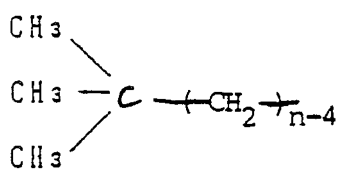

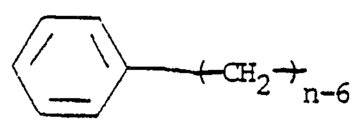

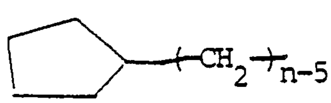

and

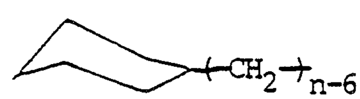

wherein n is 10 to 30, preferably 16 to 22. Among these groups, a straight-chain aliphatic hydrocarbon group is particularly preferred.

Though they are not essential, examples of the substituent $R_3$ include halogen atoms, nitro, amino, cyano, methoxy and acetoxy groups. However it is sometimes preferred to use a fluorine atom which can elevate the hydrophobic nature of the polymer compound, compared with a hydrogen atom.

Namely, the $R^3$ alkyl chain can be shortened by introducing fluorine atom(s) thereto. In a compound of the formula $C_8F_{17}(CH_2)_k$, for example, it is sufficient that k is 2, which enables the formation of a film with

10 carbon atoms.

The molecular weight of the polymer compound to be used in the present invention is not particularly restricted. Although a film can be produced according to the process of the present invention by using a polymer compound having a low molecular weight, however, the resulting film is poor in heat resistance, mechanical strength and chemical resistance. On the other hand, an excessively high molecular weight of the polymer compound brings about such a high viscosity as to make the film-formation difficult.

Accordingly, the number-average molecular weight of the polymer compound may range from about 2,000 to 300,000, preferably from about 10,000 to 150,000.

Practically available examples of the polymer compound to which a hydrophobic group has been introduced via an ionic bond are as follows:

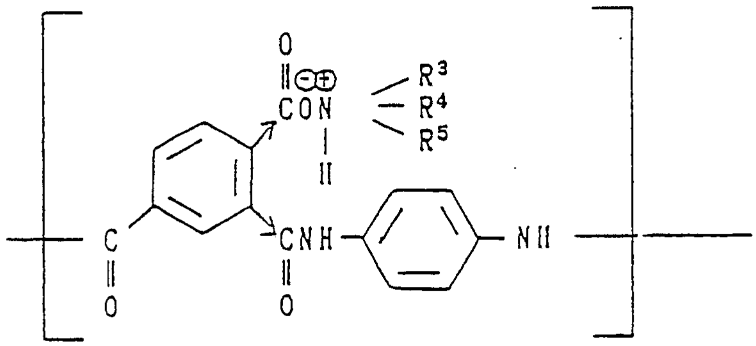

(21);

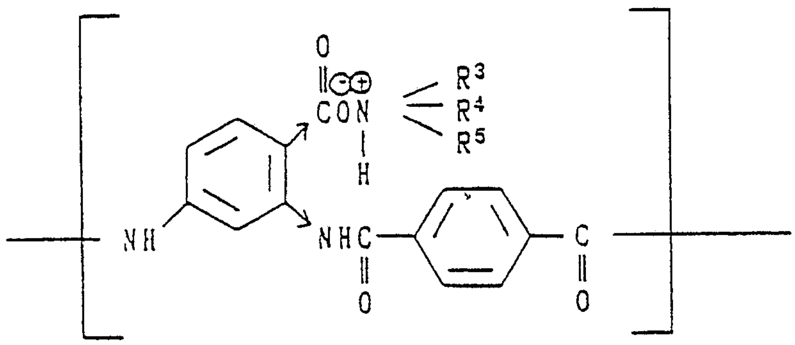

(22);

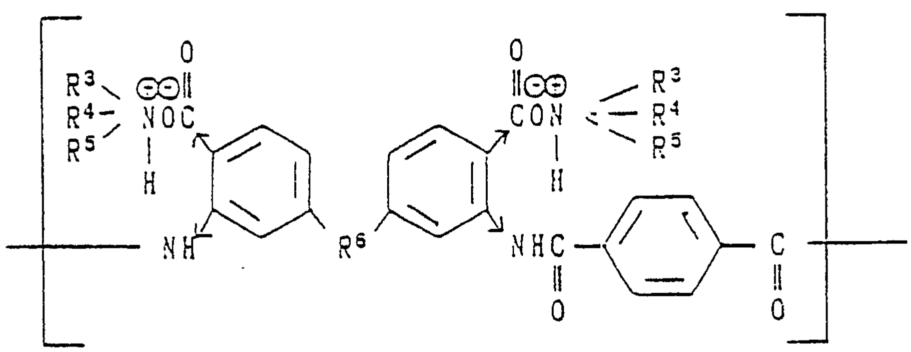

(23);

wherein $R^6$ is as defined in formula (6);

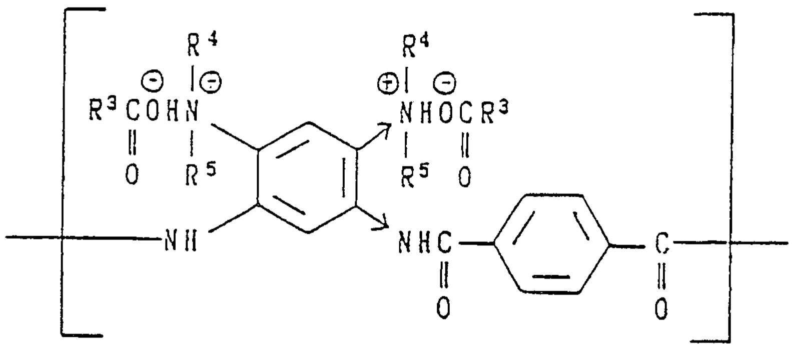

(24);

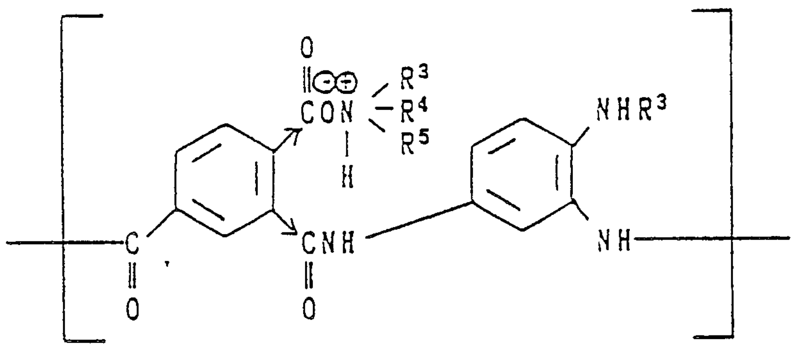

(25);

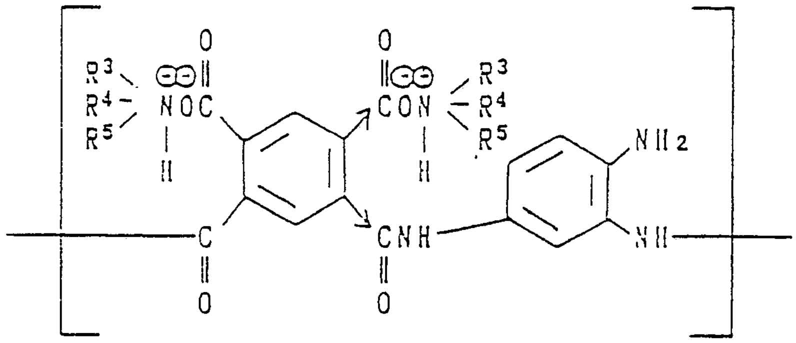

(26);

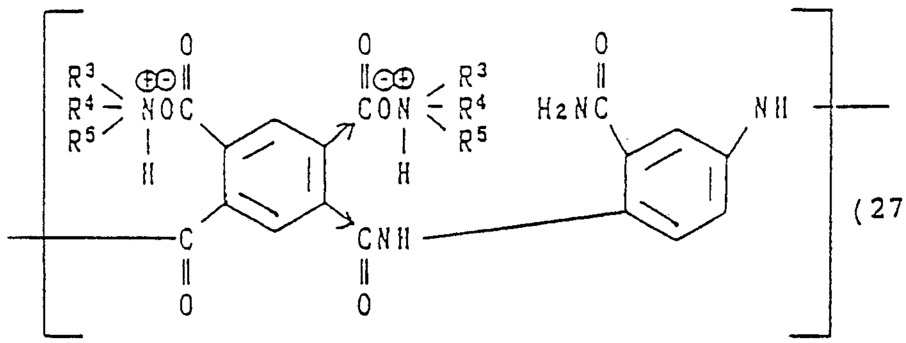

(27);

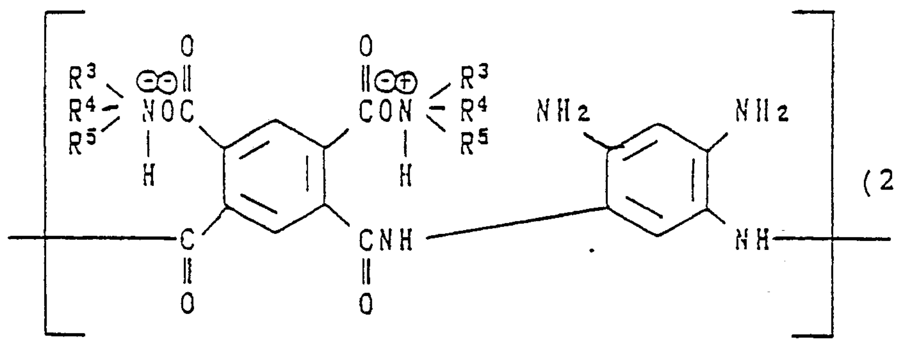

(28);

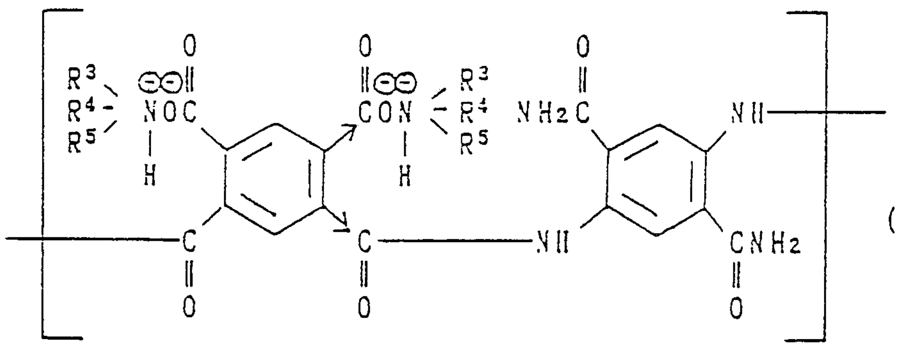

(29);

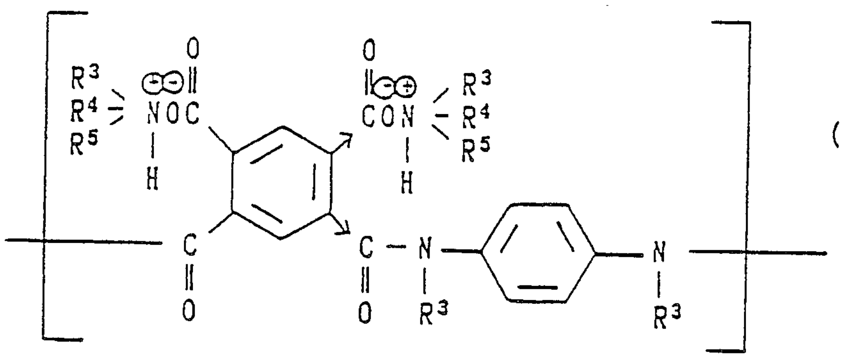

(30);

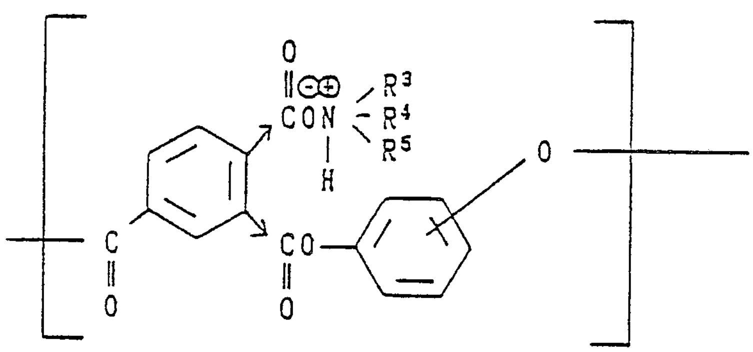

(31);

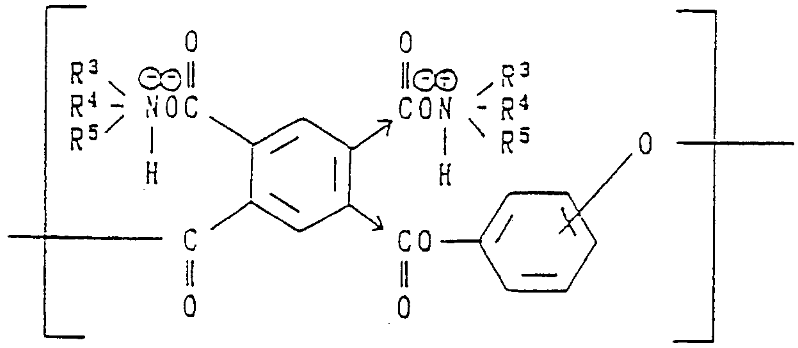

(32);

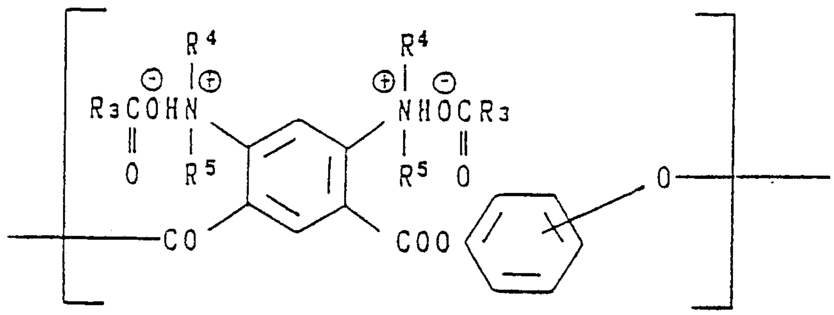

(33); and

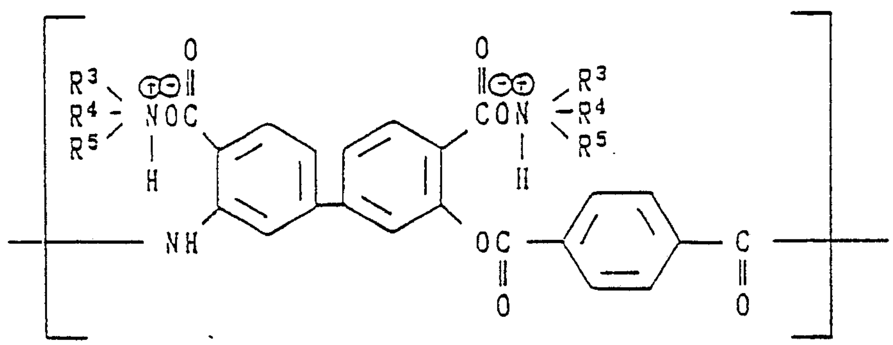

(34).

In the above formulae (3) to (34), a mark "→"represents an isomer. For example, the formula (3) represents both of the following formulae (3-1) and (3-2);

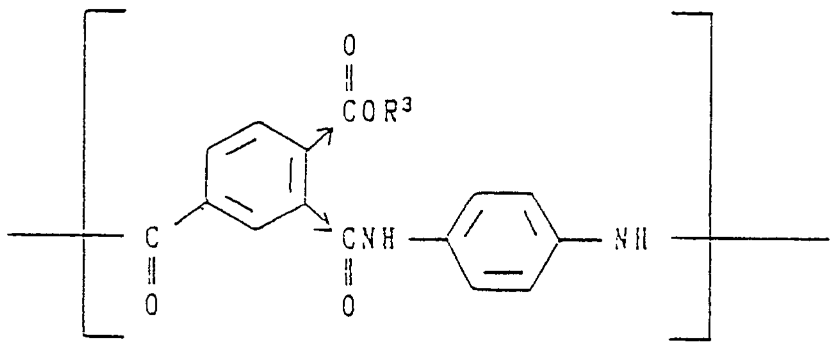

(3);

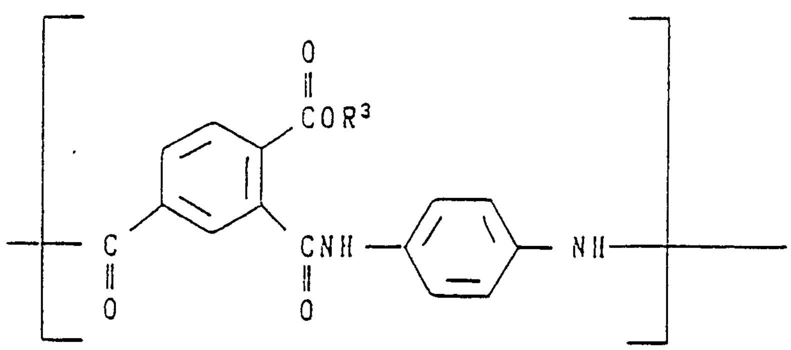

(3-1); and

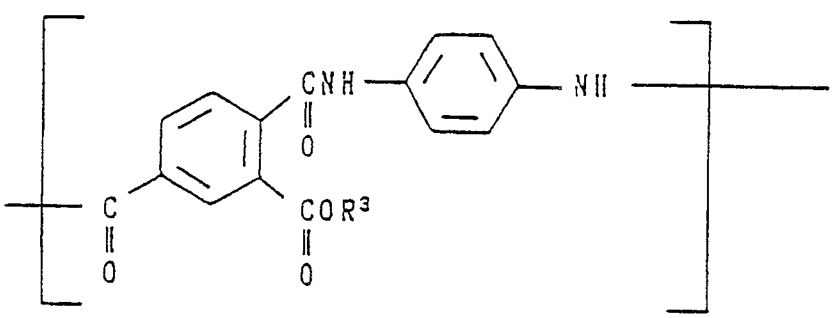

(3-2).

That is to say, the present invention involves a case wherein either the compound of (3-1) or (3-2) is present alone as well as that wherein both of the compounds of (3-1) and (3-2) are present together. In the formulae (21) to (34), at least one of $R^3$, $R^4$ and $R^5$ is the same as the $R^3$ defined in the formulae (1) to (20) and examples thereof, while the other groups each represent an optionally substituted hydrocarbon-containing group having 1 to 30 carbon atoms or a hydrogen atom. A hydrocarbon-containing group having 1 to 4 carbon atoms and a hydrogen atom are preferred. As a matter of course, a mixture of these polymer compounds are also available in the present invention.

Now the LB technique to be employed in the present invention will be described in detail.

The process for forming LB film comprises spreading a film-forming material on the surface of water, compressing the material thus spreaded on the surface of water at a constant surface pressure to form a monomolecular film, and then transferring the film formed onto a subtrate by repeatedly passing the substrate through the film. Besides the above described process (the vertical dipping method) there may be mentioned horizontal dipping method, revolving cylindrical method, etc. ("Shin Jikken Kagaku Koza" "vol. 18, "Interface and Colloid", 498-508). Any procedure may be employed without restriction, as long as it has been commonly employed in the art.

The LB technique enables the production of an orientated film whose thickness is controlled with an accuracy of several tens Å. Thus, it is an excellent method for producing a film of a thickness less than 200

Å, less than 1000 Å, several hundreds Å, or several tens Å. The film on the substrate of the present invention also has the above-mentioned characteristics. However, a film of thickness 10,000 Å or more, may be produced thereby.

It has been proposed that a modified polymer compound alone can be deposited into a film. However, it is possible to improve the film-forming properties by mixing said polymer compound with a known LB film compound, which is a preferred embodiment of the present invention.

The expression "known LB film compound" used herein means those described in, for example, the literature cited above and those known in the art. Preferable examples are the following,

comprising a hydrocarbon group having 16 to 22 carbon atoms and hydrophilic group(s):

$CH_3(CH_2)_{n-1}Z$;

$CH_2=CH(CH_2)_{n-2}Z$; and

$CH_3(CH_2)_1C=C\text{-}C=C(CH_2)_mZ$;

wherein n is 16 to 22;

1 + m = n-5; and

Z is a OH, a $NH_2$, a COOH, a $CONH_2$ or a $COOR'$ group,

wherein $R'$ is a lower aliphatic hydrocarbon group.

In order to improve the film-forming properties, a compound represented by the formula $CH_3(CH_2)_{n-1}Z$ is preferred from the viewpoints of performance and cost. On the other hand, those containing unsaturated bond(s) can be polymerized by, for example, UV-irradiation.

The ratio between at least one of these compounds and the polymer compound is not particularly specified.

When these film-forming materials are spread onto the surface of water in the Langmuir-Blodgett technique, a solvent which is insoluble in water and vaporizes into the atmosphere, for example, benzene or chloroform, is commonly employed. In the case of the polymer compound of the present invention, it is further preferred to use an organic polar solvent together with the above-mentioned one in order to elevate the solubility. Preferred examples of the organic polar solvent include N,N-dimethylformamide, N,N-dimethylacetamide, N,N-diethylformamide, N,N-diethylacetamide, N,N-dimethylmethoxyacetamide, dimethylsulfoxide, N-methyl-2-pyrrolidone, pyridine, dimethylsulfone, hexamethylphosphoramide, tetramethylenesulfone and dimethyltetramethylenesulfone.

Accordingly, it is desirable to use a mixture comprising a solvent such as benzene or chloroform and an organic polar solvent, when the polymer compound is spread together with a known LB film compound.

When an organic polar solvent is to be used together with another solvent such as benzene or chloroform at the spreading of the film, the latter solvent would vaporize into the atmosphere while the organic polar solvent would be dissolved in a large amount of water.

The substrate to be used in the present invention is not considerably restricted by anything other than the purpose of the application of the obtained film. Namely, commonly employed inorganic substrates made of, for example, glass, alumina or silica as well as those containing semiconductors of IV, III-V and II-VI groups such as metals, Si, GaAs and ZnS, ferroelectric materials such as $PbTiO_3$, $BaTiO_3$, $LiNbO_3$ and $LiTaO_3$ and magnetic thin films may be employed therefor.

In addition, a surface-treated substrate may be preferably used in the embodiment of the present invention.

Now the patterning process will be described in detail.

A LB film, built-up on a substrate, is irradiated with an excimer laser through a mask, if desired. Preferred examples of the excimer laser are KrF, ArF and XeCl types. When the film is irradiated with the excimer laser having a high energy density, the irradiated part is removed, which makes it possible to produce a patterned thin film without requiring any development step by using a developing solution. However, an organic solvent such as methanol or ethanol, aqueous ammonia, or an organic or inorganic alkaline solution may be used as a developing solution in the present invention.

The mechanism of the removal of the irradiated part has not been clarified in detail so far. It is assumed that the excitation or heat by the excimer laser of a high energy density would cause ablation. Thus, it is preferred that the pulse energy of the excimer laser is at least 5 $mJ/cm^2$, more preferably at least 10 $mJ/cm^2$, though it varies depending on the pulse interval.

Furthermore, the polymer compound of the present invention having the pattern thus obtained can be converted into a five- or six-membered ring structure to give a heat resistant polymer film pattern, when said polymer compound has a precursor structure capable of giving a five-or six-membered ring structure. Thus, it is possible to make the film resistant against a high temperature of 300 °C or above, preferably 500 °C or above, by appropriately selecting the molecular structure. Among the above compounds (1) to (34), those of the formulae (3) to (15) and (21) to (30) are capable of partial or complete ring closure so as

to give a five- or six-membered ring involving hetero atom(s). After the completion of the ring-closure, each compound has the following strucutre:

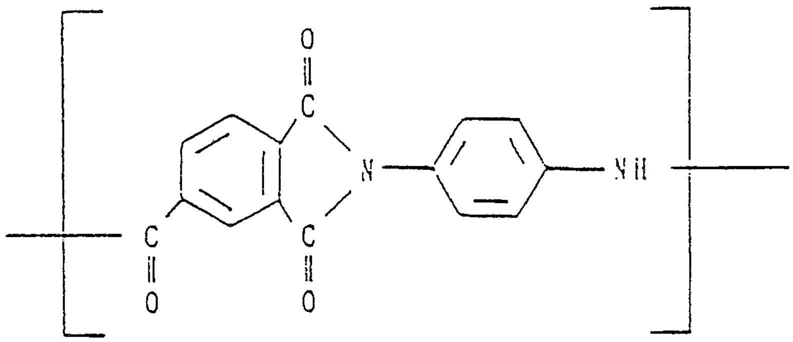

(3′);

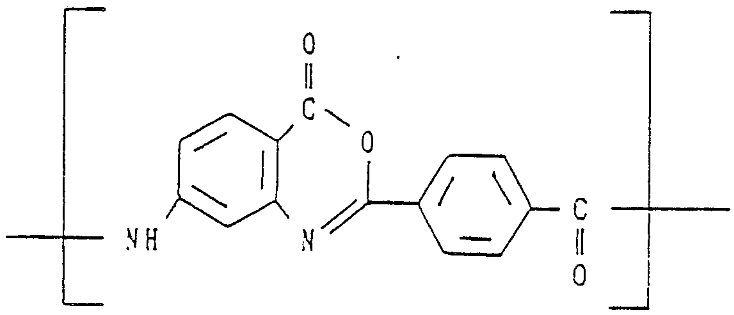

(4′);

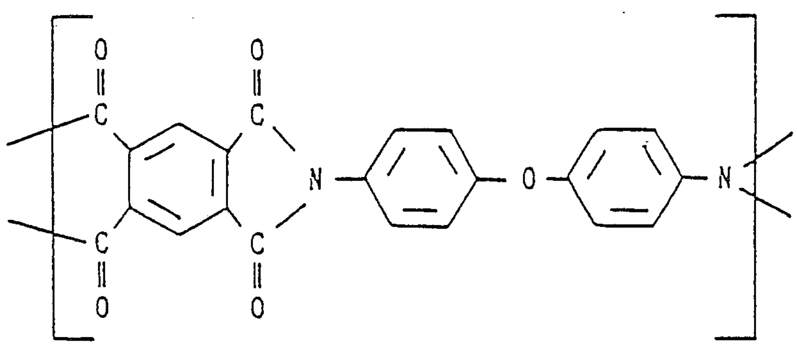

(5′);

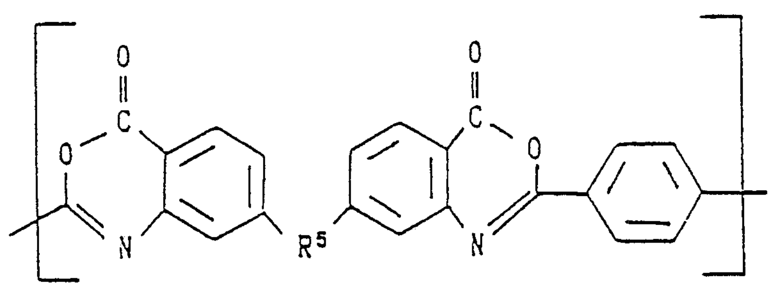

(6′);

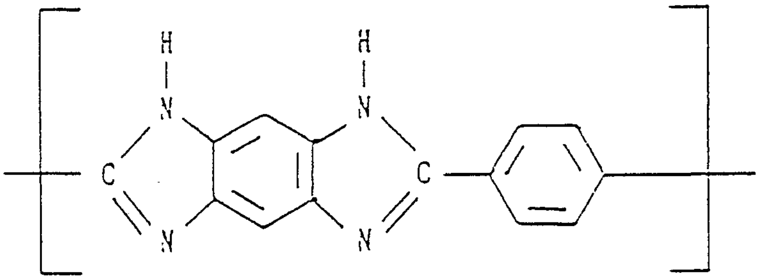

(7′);

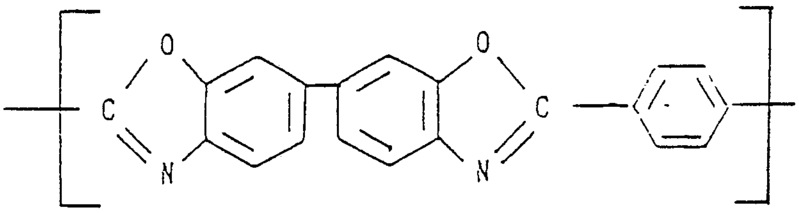

(8′);

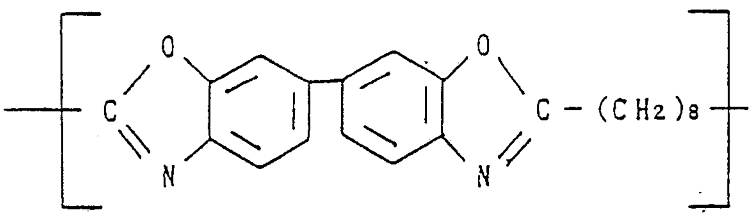

(9′);

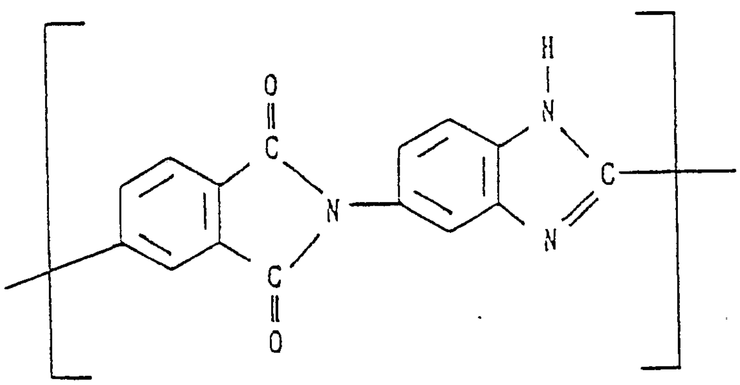

(10′);

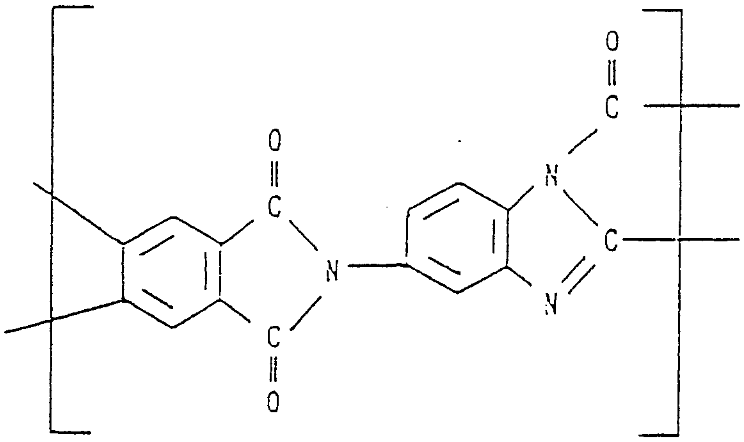

(11');

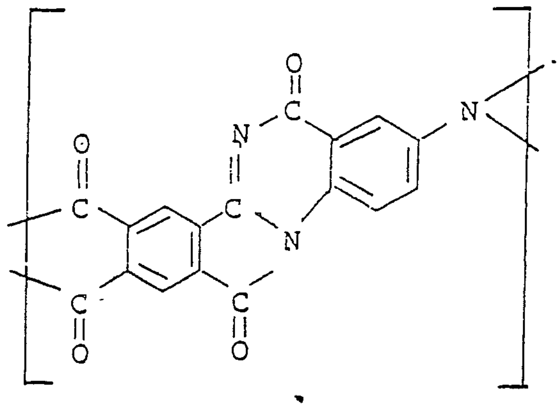

(12');

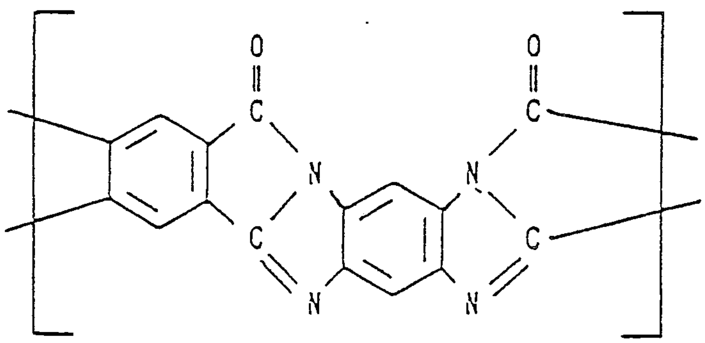

(13');

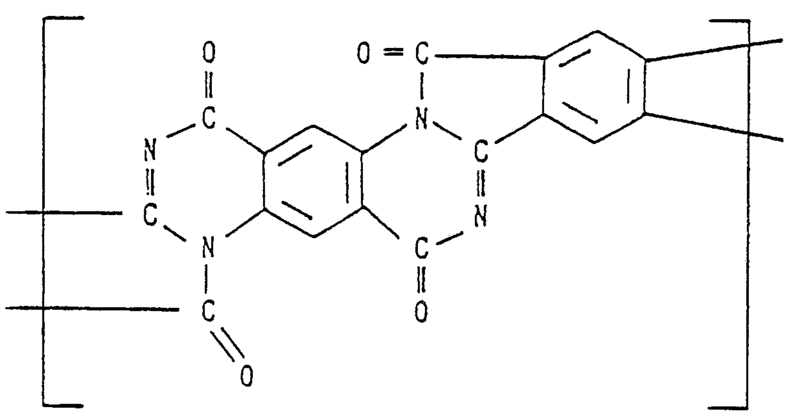

(14');

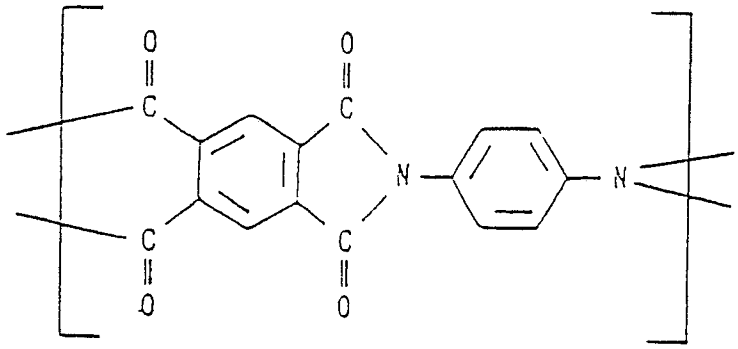

(15');

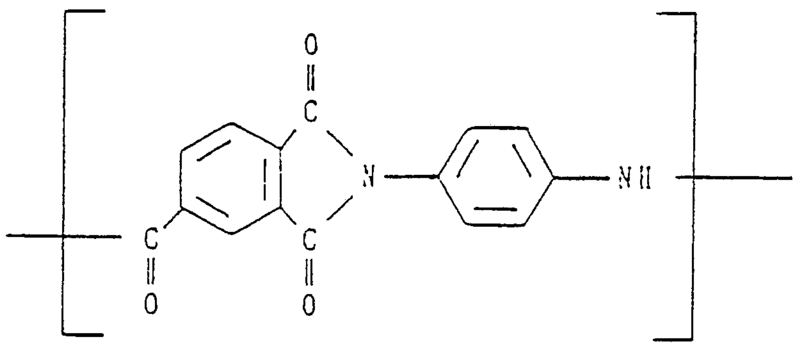

(21');

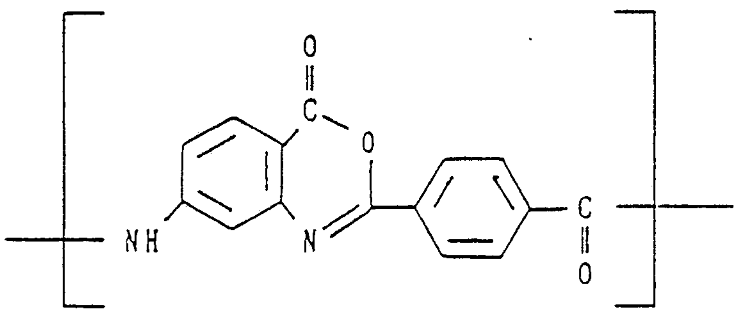

(22')

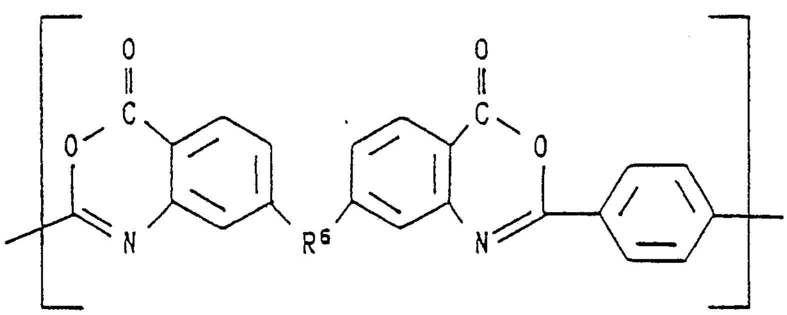

(23')

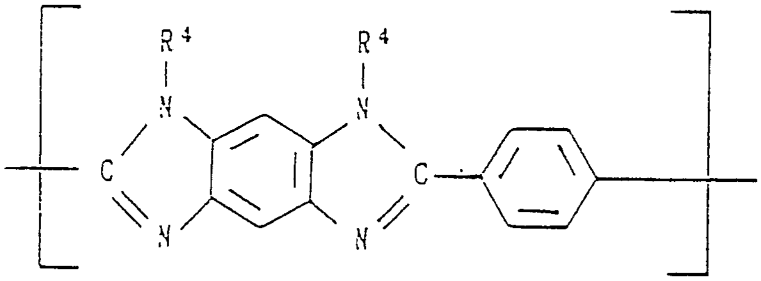

(24')

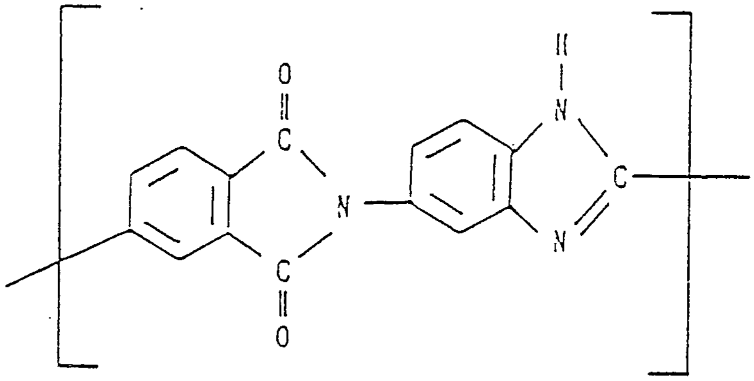

(25')

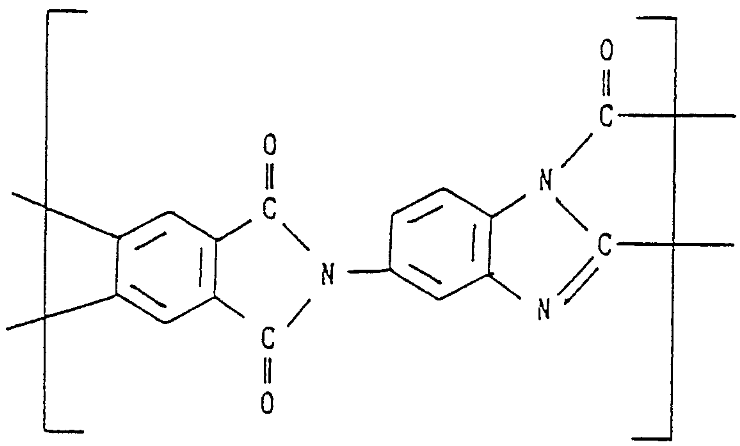

(26');

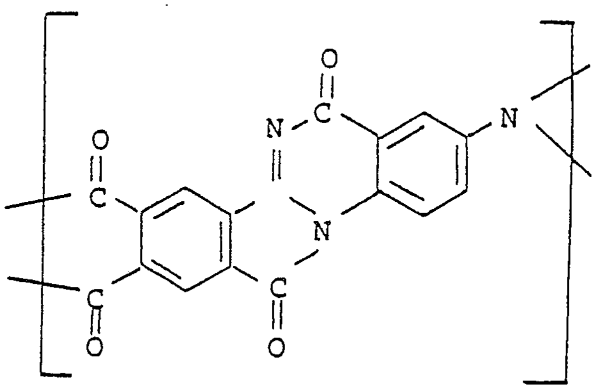

(27')

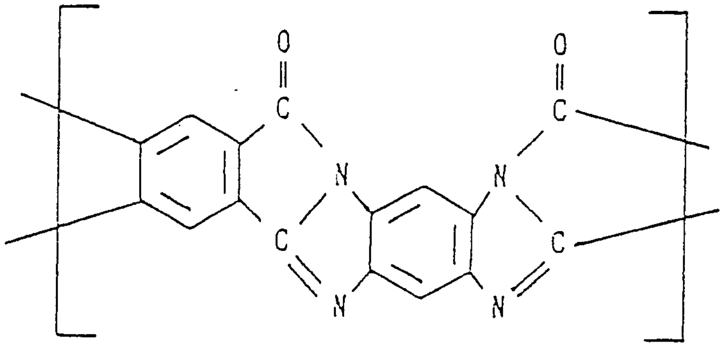

(28');

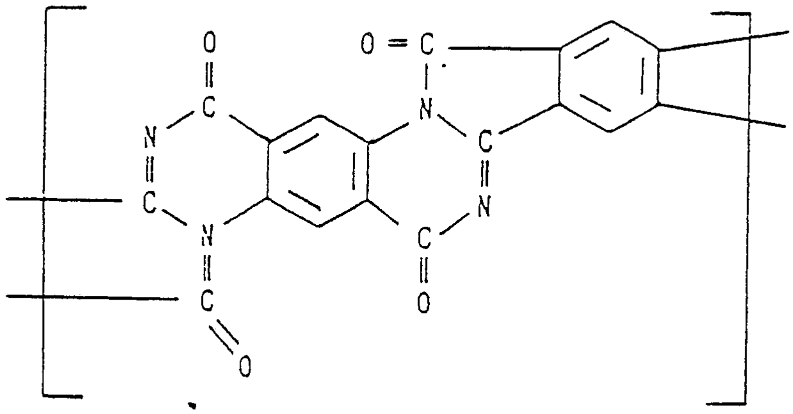

(29'); and

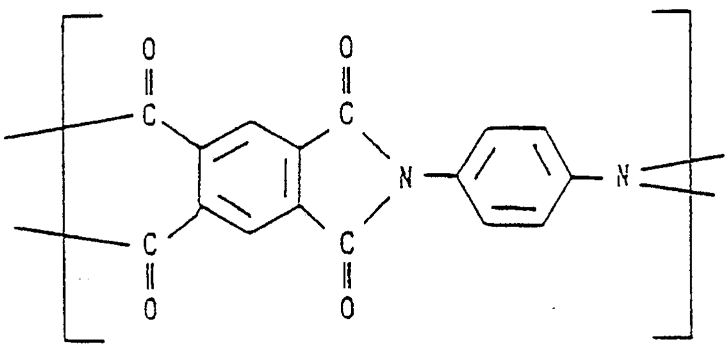

(30').

The method for the ring closure is not particularly restricted. For example, the compound of the formula (5) may be imidized to give an imide of the formula (5′) through ring closure by heating to 300 to 400 °C, as shown below.

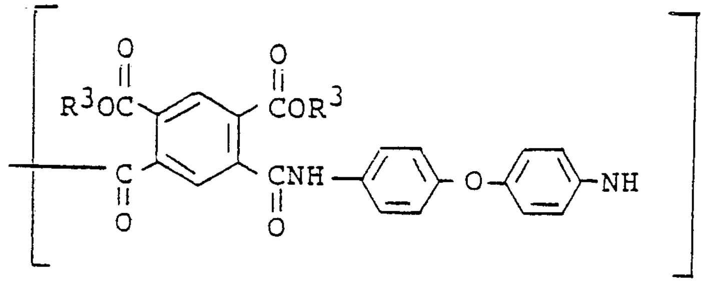

(5);

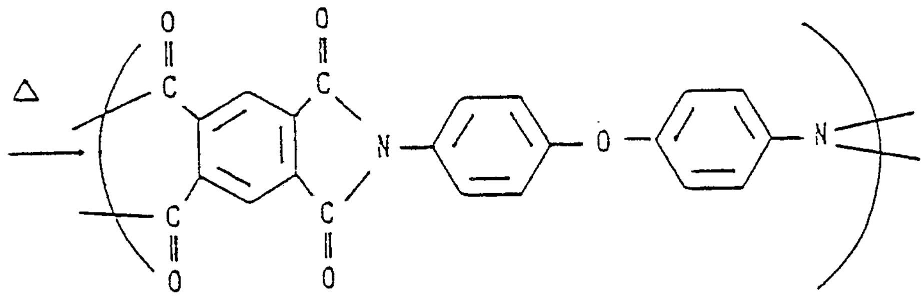


(5');

+ $2CH_3(CH_2)_{17}OH$.

In this reaction a group which has been introduced in order to make the polymer compound hydrophobic, is liberated as an alcohol. This alcohol can be vaporized at a temperature of 200 to 400 °C under a gas stream or under reduced pressure, if required. Thus, a polyimide film having excellent heat resistance can be obtained.

When a film having an excellent heat resistance is to be produced through ring closure, it is desirable therefore to select a known LB film compound which can be vaporized under the ring closure conditions from those which are cited above.

As a matter of course, a chemical curing agent such as acetic anhydride, pyridine or isoquinoline commonly employed in the imidization of a compound may be used optionally upon heating.

As described above, the film which has been produced by building-up the polymer compound of the present invention on a substrate by the Langmuir-Blodgett technique, patterning the built-up film thus obtained and optionally subjecting the same to ring closure, is excellent in heat resistance, mechanical properties and chemical resistance, and has high electric insulating characteristics. Furthermore, this film is extremely thin, namely, 10000 Å or below in thickness. The thickness thereof may be lowered to 5000 Å, 2000 Å or even 10 to 1000 Å, if desired.

It is to be noted here that this film sustains excellent physical properties, in particular, a breakdown strength of $1 \times 10^6$ V/cm or more, even at a thickness less than 1000 Å, for example, several hundreds Å or 50 to 100 Å, which makes it useful in various devices. It is expected, in particular,that a film having a thickness of 50 to a few hundreds Å would exert a specific effect such as a tunnel effect, which can be applied to various interesting purposes.

Now applications of the patterned thin film will be described.

The patterned thin film of the present invention is excellent in heat resistance, chemical resistance and mechanical properties and has an extremely low thickness, which makes it widely available in the fields of, for example, electronics, energy conversion and separation of materials.

First, the chemical resistance of this film makes it useful as a photoresist in the field of microprocessing of semiconductors. The patterned thin film of the present invention is extremely thin, which makes it available as a resist for microprocessing at a submicronic or quartermicronic level. Furthermore, the excellent heat resistance of the patterned thin film of the present invention makes it applicable to a dry etching process.

Typical examples of a dry etching process include plasma etching, reactive sputter etching and reactive ion beam etching. Namely, various materials such as Si, polysilicon, $SiO_2$, $Si_3N_4$ or Al may be processed

by these methods by appropriately selecting a reactive gas from, for example, $CF_4$, $CF_4 + O_2$, $CF_4 + H_2$, $C_3H_8$, $CCl_4$ and $BCl_3$.

Furthermore, the patterned thin film of the present invention, which is excellent in photoconductivity, optical properties, insulating characteristics, thermal properties and chemical reactivity, may be applied as such to an electrical/electronic device in the field of electronics.

The primary important electrical/electronic device involving the thin film of the present invention is a metal/insulator/semiconductor device, which will be called a MIS device hereinafter. It is a basic structure for the construction of a planar electronic device or an integrated circuit.

Figs. 1 to 7 each show a typical model of the above-mentioned MIS device. In the model of Fig. 1, the thin film of the present invention is formed on a semiconducting substrate and a metal electrode is placed thereon. The semiconductor may be selected from those of the IV group of the Periodic Table such as Si or Ge, those of the III-V group such as GaAs or GaP and those of the II-VI group such as CdTe, CdS, ZnS, ZnSe or CdHgTe. Thus, there are provided, for instance, various transducers, e.g. photoelectric conversion elements such as solar cells, light emitting elements such as LED (light emitting diode), EL (electroluminescence) or photodiods, light receiving elements, light detecting elements, gas sensors, or temperature sensor. As a matter of course, the semiconductor to be used in the present invention may be either monocrystalline, polycrystalline or amorphous.

The model of Fig. 2 is the same as that of Fig. 1 except that two or more devices are formed on a single substrate. It is an interesting example of the application of the present invention whereby a charge-transfer device such as charge-coupled device (CCD) can be obtained.

In the model of Fig. 3 a semiconductor which is frequently provided in the form of a semiconducting film is formed on an insulating substrate provided with an electrode, which may be either transparent or patterned, and the thin film of the present invention is formed thereon.

The model of Fig. 4 differs from that of Fig. 3 in that a thin film is inserted between an electrode in the side of an insulating substrate and a semiconducting film. The semiconducting film may be produced by any method commonly employed in the art, for example, molecular beam epitaxy (MBE), metal organic chemical vapour deposition (MOCVD), atomic layer epitaxy (ALE), vacuum evaporation, sputtering, spray pyrolysis or coating.

The semiconductor may be selected from those cited above regarding Figs. 1 and 2. Thus, devices similar to those described in these cases may be obtained.

In the model of Fig. 4, a semiconducting film is formed on the thin film of the present invention. It is undesirable that the heat of formation of the semiconducting film exceeds the tolerance limit of the heat resistance of the thin film of the present invention. However, a film obtained through ring-closure can sufficiently withstand the building-up of, for example, amorphous silicon. Furthermore, recent developments in the low temperature formation techniques for semiconductors will make this process applicable to a number of semiconductors.

Figs. 5 and 6 are schematic models showing typical embodiments of an MIS devices having a field effect transistor (FET) structure (hereinafter referred to as "MISFET device"), which are drived by controlling the channel current with gate electrodes and which are the most important device among MIS devices.

In the model of Fig. 5 a semiconducting substrate is used. A semiconductor which is frequently provided in the form of a semiconducting film is formed on a insulating substrate in that of Fig. 6.

The MISFET is a basic type of device and is applicable to various devices. For example, a thin film transistor for driving a liquid crystal display may be formed by constructing this sturcture on a substrate of a large area. Alternatively, an integrated circuit may be formed by elevating the degree of integration of the same.

Furthermore, interesting examples of the application thereof can be obtained by removing the gate electrode from the model of Fig. 5 or 6. When an insulating film is incorporated thereto, optionally together with a film, sensitive to, for example, an ion, a gas or an active substance, an ion-sensitive FET (ISFET), a gas-sensitive FET (ChemFET), an immunological FET (IMFET) or an enzyme FET (ENFET) can be obtained.

The mechanism of each FET can be explained by the field effect that appears when an ion, a gas or an active substance comes into contact with the surface of the gate insulating film. The use of the thin film of the present invention makes further modifications of the same with various organic materials advantageous, compared to a case where conventional inorganic material is employed. It is particularly advantageous to utilize the interaction between hydrophobic long-chain alkyl group(s) in the film, if any, and a hydrophobic portion of a protein.

In the model of Fig. 7 a semiconducting film is formed on a quartz substrate and an insulating film and

an ion-sensitive film are further located thereon. The thin film of the present invention is available as said insulating film.

It is preferred to apply the present invention to such a case that a compound semiconductor which can hardly be formulated into an excellent insulating film by a conventional manner such as oxidation, for example, those belonging to the groups of III-V and II-VI, is to be used as a semiconductor in the construction of a device of the MIS structure. From the above point of view, GaAs is used in practice as a metal-semiconductor FET (MESFET). It is expected that the use of the same as the MIS structure would further improve the performance of the obtained device.

The application of GaAs to the construction of a MIS integrated circuit is advantageous not only in that the driving voltage can be lowered thereby, but also in that an integrated circuit capable of working at a high speed can be readily produced by taking advantage of the large carrier mobility in the GaAs semiconductor.

The second important electrical/electronic device comprising the thin film of the present invention is a metal/insulator/metal device, which will be called a MIM device.

Figs. 8 to 10 each show a model of the MIM device wherein a metal, an insulating film and another metal is formed in this order on an insulating substrate or a semiconducting substrate.

Fig. 8 shows the structure of a capacitor. When the change in the capacitance caused by moisture is monitored, it may serve as a moisture sensor. Furthermore, a transistor of the MIM structure may be formed by using the same.

The structure shown in Fig. 9 enables the construction of a hot electron transistor.

As shown in Fig. 10, a capacitor for a memory cell of a VLSI may be obtained by forming a capacitor on a semiconductor or a semiconducting device.

Furthermore, the structure of Fig. 10 may be applied to a device wherein a hot electron is introduced into a semiconductor. Furthermore, a Josephson junction (JJ) device may be produced by substituting the metal with a superconductor such as Nb.

The third electrical/electronic device comprising the thin film of the present invention is an insulating film/metal (IM) device. Fig. 11 shows a typical model of the most simple type thereof the thin film of the present invention is formed as an insulating film on a metal.

An example of the application of this device is a liquid crystal orientation film obtained by forming the thin film of the present invention on a patterned electrode which is usually a transparent electrode such as ITO.

Figs. 12 and 13 show additional examples of the application of the above-mentioned device. In each case, the thin film of the present invention is formed between two electrodes independently from each other. The device thus formed is available as, for example, a sensor for moisture or a gas.

In addition to the examples of the electrical/electronic devices comprising the thin film of the present invention, those described in the references shown above, in particular, "Thin Solid Films", P.S. Vincett and G.G. Roberts, 68, 135 -171 (1980) may be cited here as application examples of the present invention.

Further examples of semiconductor devices and compound semiconductor devices may be found in "Fundamentals of Semiconductor Devices", E.S. Yang, MacGraw-Hill (1978) and "Kagobutus Handotai Device I and II", Imai et al., Kogyo Chosa Kai (1984).

The refractive index of the thin film of the present invention may be adjusted by precisely controlling the thickness and selecting an appropriate compound which makes it highly useful as a component of an optical circuit.

In the technique commonly employed for the production of a mixed or laminated film comprising a functional LB material and a fatty acid, said fatty acid may be substituted by the polymer of the present invention, whereby various functions may be imparted to the film thus obtained. Therefore the film thus produced is widely applicable to various purposes. For example, a film which contains a colorant or an enzyme and thus available in a photoelectrical transducer or a biosensor may be obtained thereby.

According to the present invention, a patterned thin film can be produced without requiring any developing procedure by irradiating a polymer LB film with an excimer laser having a high energy density.

Furthermore, a patterned thin film, which is excellent in heat resistance and has good chemical resistance and mechanical properties in addition to a low thickness as not usually achieved in a conventional manner, namely, 10000 Å or below or 10 to 1000 Å, if required, can be produced by partially or completely cyclizing said polymer and simultaneously vaporizing a known LB film compound mixed therewith.

To further illustrate the present invention, the following Example will be given.

Example 1

2.18 g (0.01 mol) of pyromellitic dianhydride was reacted with 5.40 g (0.02 mol) of stearyl alcohol in a flask under a dry nitrogen gas stream at approximately 100 °C for three hours.

The reaction product thus obtained was dissolved in 40 ml of hexamethylphosphoric triamide and cooled to 0 to 5 °C. Next, 2.38 g of thionyl chloride was added dropwise thereto at approximately 5 °C. After the completion of the addition, the resulting mixture was maintained at approximately 5 °C for an hour to thereby complete the reaction.

Subsequently 2 g (0.01 mol) of diaminodiphenyl ether dissolved in 50 ml of dimethylacetamide was added dropwise thereto at 0 to 5 °C. After the completion of the addition, the resulting mixture was allowed to react for an hour. Next, the reaction mixture was poured into 600 ml of distilled water to thereby precipitate the reaction product. The precipitate was filtered and dried under reduced pressure at approximately 40 °C. Thus approximately 9 g of a pale yellow powder was obtained.

The powder thus obtained was subjected to IR spectrometry, thermogravimetric analysis (TGA-DTA) and molecular weight- determination by GPC.

A mixture of the obtained powder and stearyl alcohol at a molar ratio of 1 : 1 was dissolved in a mixture of distilled chloroform and dimethylacetamide (8 : 2 by volume) to thereby give 25 ml of a solution for the spreading of an LB film.

Then a monomolecular film was prepared by spreading the solution obtained above on the surface of redistilled water at 20 °C. Then the obtained film was vertically built-up on a silicon semiconducting substrate while maintaining the surface pressure at 2.5 Pa (25 dyne/cm) a building-up rate of 10 mm/min to thereby form 31 layers. The built-up film thus obtained was irradiated with 10 pulses of an ArF excimer laser of a pulse energy of 50 $mJ/cm^2$ through a test mask. As a result, the irradiated part of the built-up film was removed and thus a positive pattern (0.4 $\mu m$) was formed. The sensitivity was as high as 500 $mJ/cm^2$.

The patterned built-up film was further heated to 400 °C for an hour. It was proved from peaks at 1790 $cm^{-1}$ and 1710 $cm^{-1}$ in FT-ATR-IR analysis that an $\alpha,\beta$-unsaturated five-membered ring imide ring was formed thereby.

Furthermore, silicon was etched with a gas mixture ($CF_4$ + $O_2$) by using the above-mentioned resist pattern as a mask. As a result, it was found by Talystep method that a difference in the level at a depth of 2 $\mu m$ was formed in the silicon. A similar result was obtained by irradiating the film with 25 pulses of an ArF excimer laser of a pulse energy of 25 $mJ/cm^2$. Furthermore, a similar result was obtained by irradiating the same with 70 pulses of an ArF excimer laser of a pulse energy of 10 $mJ/cm^2$.

## Claims

1. A process for the production of a patterned thin film which comprises building-up a polymer compound, which has linear repeating units,wherein a first organic group $R^1$ having at least two carbon atoms and at least 2 valences and a second organic group $R^2$ having at least two carbon atoms and at least 2 valences are alternately bound to each other via a divalent binding group formed by a reaction between an acidic group A containing at least one hetero atom and a basic group B containing at least one hetero atom and at least one hydrocarbon-containing group $R^3$ having 10 to 30 carbon atoms and optionally containing substituent(s) is bound to said repeating unit via a covalent or ionic bond, optionally together with a known LB film compound by Langmuir-Blodgett's technique and irradiating the built-up film thus obtained with an excimer laser of a pulse energy of at least 5 $mJ/cm^2$.

2. A process for the production of a patterned thin film as claimed in Claim 1, wherein said polymer compound has a precursor structure capable of forming a five- or six-membered ring containing hetero atom(s) and the built-up film remaining after the patterning by the irradiation with the excimer laser is reacted to thereby form said five- or six-membered ring containing hetero atom(s).

FIG. 1

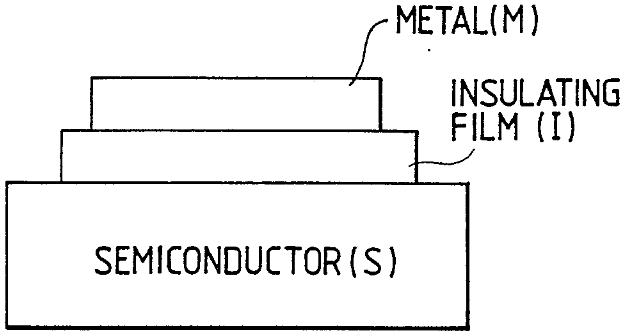


FIG. 2

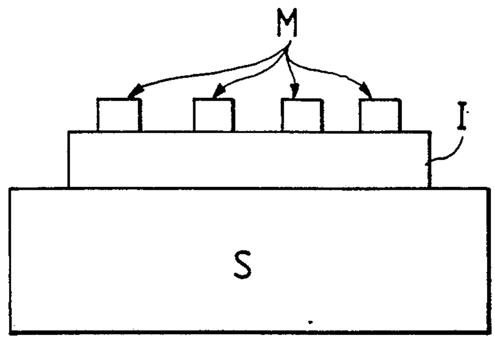


FIG. 3

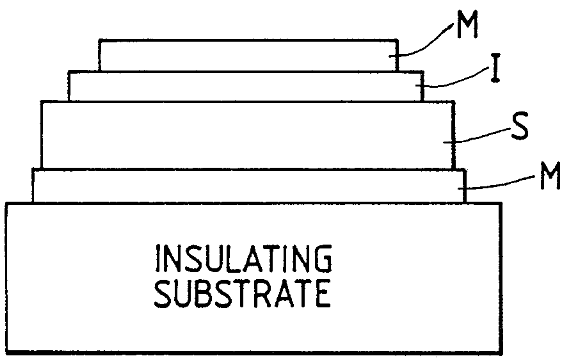


FIG. 4

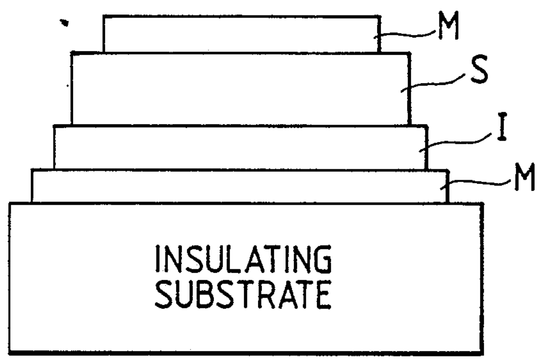


FIG. 5

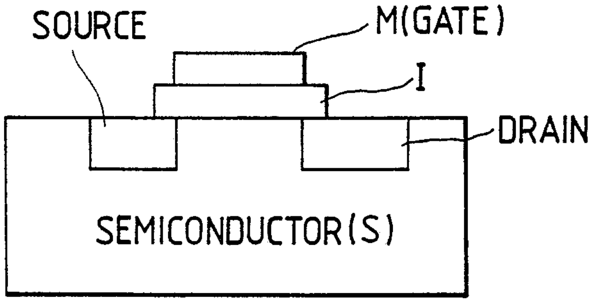


FIG. 6

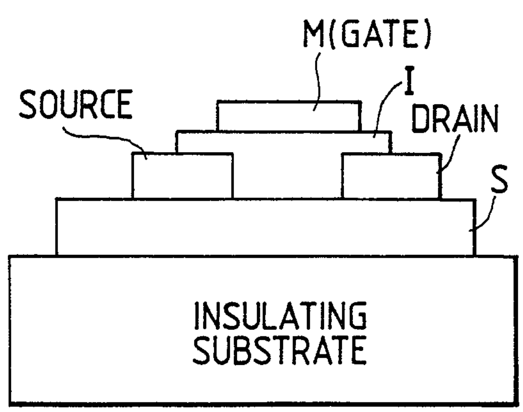

FIG. 7

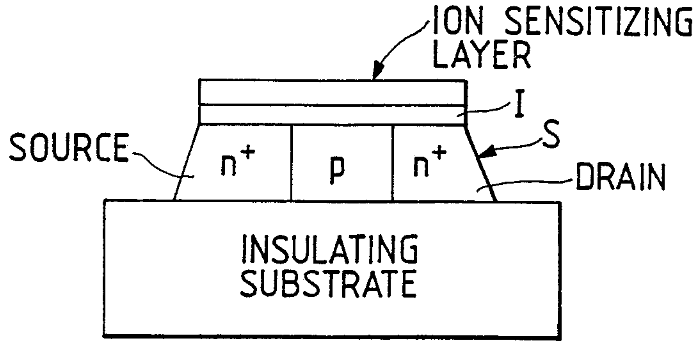


FIG. 8

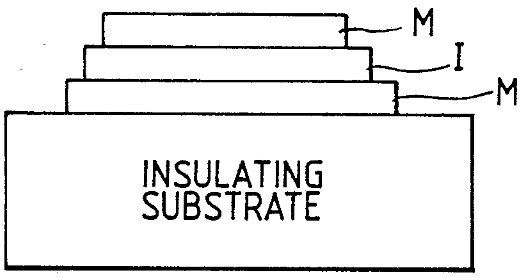


FIG. 9

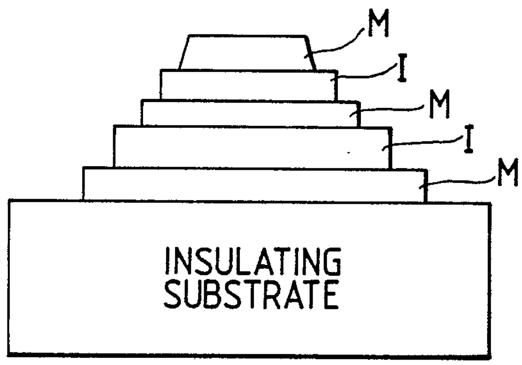


FIG. 10

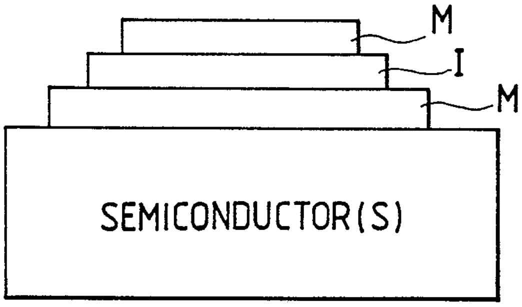


FIG. 11

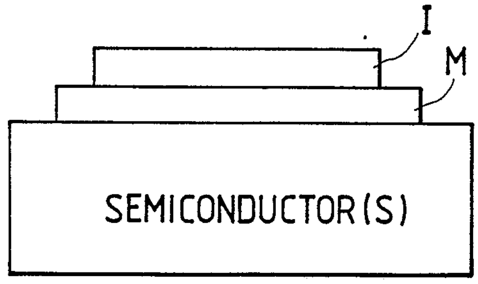

FIG. 12

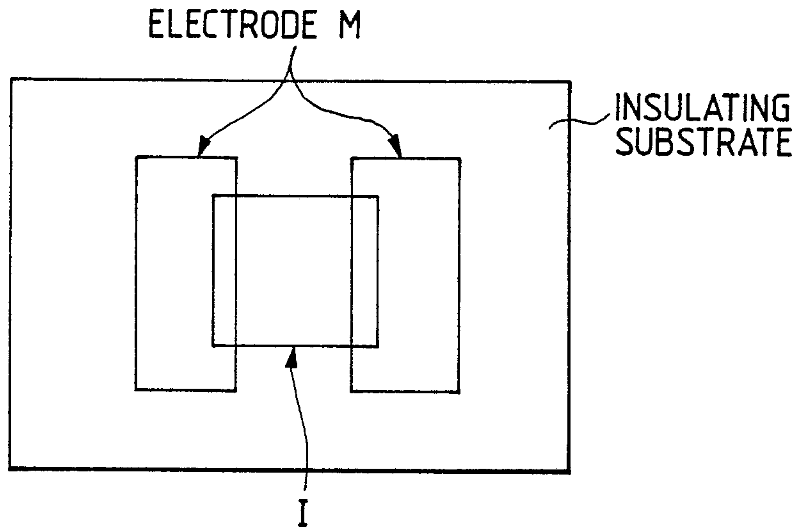
ELECTRODE M
INSULATING SUBSTRATE
I

FIG. 13

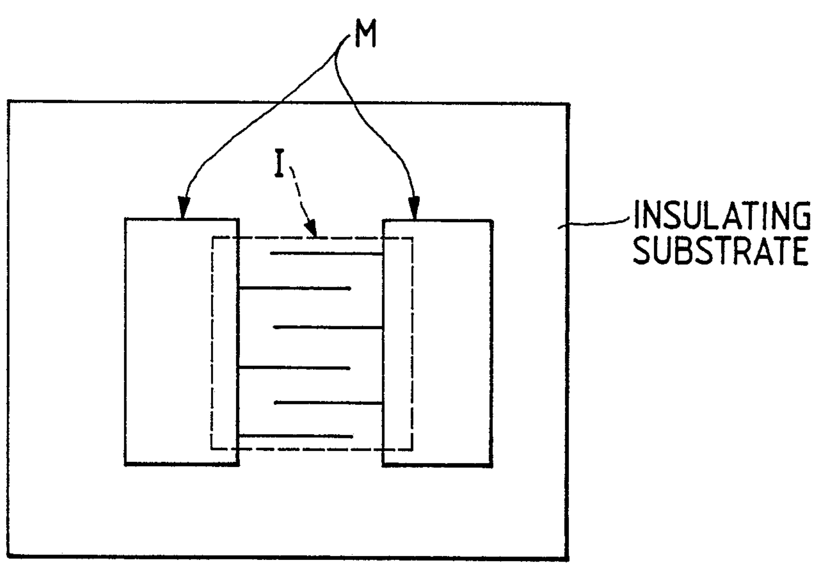
M
I
INSULATING SUBSTRATE